Europäisches Patentamt

European Patent Office

Office européen des brevets

(19)

(11) EP 0 890 844 A2

(12) **EUROPÄISCHE PATENTANMELDUNG**

(43) Veröffentlichungstag:
13.01.1999 Patentblatt 1999/02

(51) Int. Cl.$^6$: **G01R 19/165**

(21) Anmeldenummer: 98111393.9

(22) Anmeldetag: 20.06.1998

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **12.07.1997 DE 19729904**

(71) Anmelder:
**Mannesmann VDO Aktiengesellschaft
60388 Frankfurt am Main (DE)**

(72) Erfinder: **Ziegler, Harald
63128 Dietzenbach (DE)**

(74) Vertreter:
**Klein, Thomas, Dipl.-Ing.
Kruppstrasse 105
60388 Frankfurt (DE)**

(54) **Schaltungsanordnung zur Überwachung von durch eine Last fliessenden Strömen**

(57) Die Erfindung betrifft eine Schaltungsanordnung zur Überwachung von durch eine Last fliessenden Strömen, insbesondere für Kraftfahrzeuge, mit einer in Reihe mit der Last geschalteten Strommeßeinrichtung, welche mit einer Vergleichseinrichtung verbunden ist.

Eine Schaltungsanordnung, welche bei zuverlässigem Steuern der Last gleichzeitig eine genaue Strommessung erlaubt, weist eine Stromumsetzungseinrichtung (R2) auf, welche mit einer Auswerteeinheit (S) verbunden ist, wobei in Abhängigkeit eines von der Stromumsetzungseinrichtung (R2) bereitgestellen Referenzwertes die Vergleichseinrichtung (V) den an der Auswerteeinheit (S) anlegenden Strom steuert.

Figur

EP 0 890 844 A2

**Beschreibung**

Die Erfindung betrifft eine Schaltungsanordnung zur Überwachung von durch eine Last fließenden Strömen, insbesondere für Kraftfahrzeuge, mit einer in Reihe mit der Last geschalteten Strommeßeinrichtung, welche mit einer Vergleichseinrichtung verbunden ist.

Es ist hinreichend bekannt, den durch eine Last fließenden Strom mittels eines Shunts zu bestimmen. Dabei wird der Shunt mit der Last in Reihe geschaltet und der am Shunt entstehende Spannungsabfall als Maß für den Strom ausgewertet.

Üblicherweise ist der Shunt zwischen Last und Masse angeordnet.

Der Spannungsabfall am Shunt ist dabei dem durch die Last fließendem Strom direkt proportional.

Auswerteeinrichtungen erfassen Spannungen, welche sich auf das Masse-Signal beziehen. Soll aber eine High-Side-Ansteuerung der Last verwendet werden, ist die Spannung am Shunt immer auf eine Betriebsspannung bezogen.

Beträgt der Spannungsabfall am Shunt zudem nur wenige Millivolt, ist eine zuverlässige Auswertung nicht möglich.

Der Erfindung liegt somit die Aufgabe zugrunde, eine Schaltungsanordnung anzugeben, welche bei zuverlässigem Steuern der Last gleichzeitig eine genaue Strommessung erlaubt.

Erfindungsgemäß wird die Aufgabe dadurch gelöst, daß eine Stromumsetzungseinrichtung mit einer Auswerteeinheit verbunden ist, wobei in Abhängigkeit eines von der Stromumsetzungsseinrichtung bereitgestellten Referenzwertes die Vergleichseinrichtung den an der Auswerteeinheit anliegenden Strom steuert.

Der Vorteil der Erfindung besteht darin, daß mit nur einer Einrichtung sowohl der Referenzwert für die Vergleichseinrichtung festgelegt wird, als auch der zu messende Strom eine solche Größenordnung erreicht, daß eine zuverlässige Auswertung des Stromes durch die Auswerteeinheit möglich ist.

In einer Weiterbildung ist zwischen der Stromumsetzungseinrichtung und der Auswerteeinheit ein Stromspiegel geschaltet, welcher vom Ausgang der Vergleichseinrichtung derart gesteuert wird, daß der Spannungsabfall an der Strommeßeinrichtung gleich dem Spannungsabfall an der Stromumsetzungseinrichtung ist.

Die Verwendung des Stromspiegels erlaubt eine dynamische Anpassung des Ausgangssignals an die tatsächlich vorhandenen Verhältnisse.

In einer Weiterbildung weist die Stromumsetzungseinrichtung einen inneren Widerstand auf, welcher größer ist als der innere Widerstand der Strommeßeinrichtung.

Die für die Schaltungsanordnung notwendige Stromumsetzung ist somit auf einfache Art und Weise einstellbar.

Die Vergleichseinrichtung ist dabei vorteilhafterweise als Differenzverstärker ausgebildet.

Das Ausgangssignal wird über eine Glättungseinrichtung der Auswerteeinheit zugeführt.

Damit die Vergleichseinrichtung auch Signale verarbeiten kann, die außerhalb ihres Arbeitsbereiches liegen, ist die Vergleichseinrichtung mit einer Spannungserhöhungsschaltung verbunden.

In einer Ausführung ist die Last eine induktive Last, insbesondere ein Ventil zum Steuern eines Kompressors einer Klimaanlage.

Die Ansteuerung der Last erfolgt dabei mit Hilfe eines pulsweitenmodulierten Signals. Dies hat den Vorteil, daß durch die PWM-Steuerung die Betriebsspannung langsam an den Einschaltpunkt der Last herangezogen wird und nur so weit magnetische Energie durch das PWM-Signal zugeführt wird, wie es für diesen Vorgang notwendig ist. Das bisher bekannte Einschaltgeräusch der Last, welches auf die Umwandlung von überschüssiger magnetischer Energie in mechanische Energie zurückzuführen ist, unterbleibt durch diese Art des gleitenden Einschaltens. Im Augenblick des Einschaltmomentes des Elektromagnetventiles ist ein minimierter Geräuschpegel vernehmbar.

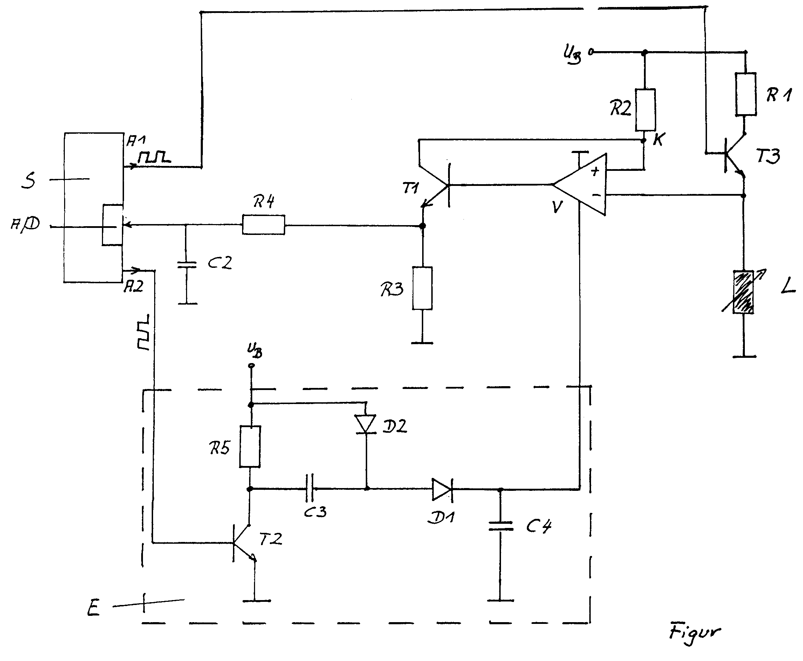

Die Erfindung läßt zahlreiche Ausführungformen zu. Eines davon soll anhand der in der Zeichnung dargestellten Figur näher erläutert werden.

In der Figur ist eine Schaltungsanordnung zur Steuerung und Überwachung eines Elektromagnetventils L in einem Kompressor einer Klimaanlage eines Kraftfahrzeuges dargestellt.

Das Ventil L, welches an Masse liegt, wird von einem Steuergerät S über die Basis eines Transistors T3 zu- oder abgeschaltet.

Im Emitterzweig des Transistors ist ein Shunt R1 angeordnet, der mit der Betriebsspannung $U_B$ verbunden ist. Im Kraftfahrzeug beträgt diese Betriebsspannung $U_B$ üblicherweise 12 oder 24 Volt. Der Widerstand R1 ist gleichzeitig mit dem nichtinvertierenden Eingang eines als Differenzverstärker arbeitenden Operationsverstärkers V verbunden.

Ein zweiter Widerstand R2 ist einerseits ebenfalls mit der Betriebsspannung $U_B$ und andererseits mit dem invertierenden Eingang des Operationsverstärkers V verbunden. Am Knotenpunkt K ist der Widerstand R2 über den als Stromspiegel geschalteten Transistor T1 mit einem weiteren Widerstand R3 verbunden, der zwischen Masse und dem Emitter des Transistors T1 liegt. Der Ausgang des Operationsverstärkers V führt an die Basis des Transistors T1.

Der Widerstand R1 und der Emitter des Transistors T1 sind über einen Tiefpaß R4, C2 mit dem A/D-Wandler des Steuergerätes S verbunden.

Der Operationsverstärker V ist mit einer Spannungsverdopplungseinrichtung E verbunden. Diese Spannungsverdopplungseinrichtung E besteht aus einem Transistor T2, welcher mit seiner Basis an einen zweiten PWM-Ausgang A2 des Steuergerätes S geschaltet ist. Der Kollektor ist einerseits über einen Widerstand R5 und eine Diode D2 mit der Diode D1 verbunden. Andererseits ist der Kollektor des Transistors T2 über einen Kondensator C3 mit der Diode D1 verbunden. Die Diode D1 ist mit dem Operationsverstärker V verbunden und über den Kondensator C4 an Masse geführt.

Die oben beschriebene Schaltung funktioniert wie folgt:

Das Steuergerät S steuert von seinem ersten PWM-Ausgang A1 das Ventil L mit einem pulsweitenmodulierten Signal an, wobei der Strom im Bereich von 0 bis 1 A schwankt.

Der Widerstand R2 ist größer dimensioniert als der Widerstand R1. Der durch den Widerstand R1 fließende Strom $I_{R1}$ entspricht dem Laststorm $I_{LAST}$ in der Größenordnung von 0 - 1A.

Der durch den Widerstand R2 fließende Strom $I_{R2}$ ist der Meßstrom $I_{Meß}$, welcher im mA-Bereich liegt.

Der Spannungsabfall über dem Widerstand R1 entspricht dem durch die Last fließendem Strom $I_{LAST}$ und der Spannungsabfall über dem Widerstand R2 stellt ein Vergleichspotential dar. Die beiden gemessenen Spannungspotentiale werden durch den Operationsverstärker V miteinander verglichen.

Der Operationsverstärker V steuert den Transistor T1 bis der Spannungsabfall $U_{R2}$ am Widerstand R2 gleich dem Spannungsabfall $U_{R1}$ am Widerstand R1 ist.

Für den Meßstrom gilt

$$I_{Meß} = I_{LAST} \cdot \frac{R1}{R2}$$

$\frac{R1}{R2}$ ist somit der Faktor zur Umsetzung der Ströme.

Durch eine Stromdämpfung wird ein auswertbares Strommeßsignal $I_{Meß}$ erhalten.

Um eine Auswertung durch das Steuergerät S zu ermöglichen, muß dieser Meßstrom $I_{Meß}$ an den Eingangsspannungsbereich des A/D-Wandlers A/D angepaßt werden. Dies erfolgt durch den Widerstand R3. Am A/D-Wandler des Steuergerätes liegt somit folgende Spannung an

$$U_{A/D} = I_{Meß} \cdot R3 = I_{LAST} \cdot \frac{R1}{R2} \cdot R3$$

Dadurch ist eine zuverlässige Bestimmung des durch das Ventil L fließenden Stromes möglich.

Das Steuergerät S vergleicht diesen so gemessenen Strom $I_{LAST}$ als Istwert mit einen in ihm abgespeicherten Sollwert $I_{SOLL}$. In Abhängigkeit dieses Vergleiches wird das Pulsweitenverhältnis des Ansteuersignals geändert.

Ist $I_{LAST} > I_{SOLL}$ wird das PWM-Signal vom Steuergerät S verkleinert. Ist $I_{LAST} < I_{SOLL}$ wird das PWM-Signal vergrößert. Bei Gleichheit bleibt das anliegende PWM-Signal erhalten.

Da auch das am A/D-Wandler des Steuergeräts S anliegende Meßsignal $U_{A/D}$ pulsierend ist, wird über einen Tiefpaß R4 und C2 dieses Signal geglättet.

Vorteilhafterweise weist die erfindungsgemäße Schaltungsanordnung eine Spannungsverdopplungseinrichtung für den Operationsverstärker V auf. Um den Bereich des Operationsverstärkers zu erweitern, mit dem Hintergrund auch Lastsignale zu verarbeiten, die größer sind als für den Arbeitsbereich des Operationsverstärkers vorgesehen ist, wird der Transistor T2 konstant mit einem PWM-Signal von 50 % angesteuert.

Ist der Transistor T2 leitend (High-Signal liegt an), so ist der Widerstand R5 fest auf Masse geschaltet. Beträgt die Betriebsspannung $U_B$ z. B. 12 V lädt sich der an 0 V liegende Kondensator C3 auf 12 V auf. Am Kondensator C4 stellen sich ebenfalls 12 V ein, die somit auch am Operationsverstärker V anliegen.

Ist im anderen Fall der Transistor T2 gesperrt (Low-Signal), liegt der Kondensator C3 grundsätzlich auf 12 V. Die Diode D2 sperrt, da am Verbindungspunkt der Diode D2 mit dem Kondensator C3 24 V anliegen. Diese 24 V stehen auch am Kondensator C4. Somit liegen am Oprationsverstärker V zu diesem Zeitpunkt ebenfalls 24 V Betriebsspannung an.

**Patentansprüche**

1. Schaltungsanordnung zur Überwachung von durch Lasten fließenden Strömen, insbesondere für Kraftfahrzeuge, mit einer in Reihe zur Last geschalteten Strommeßeinrichtung, welche mit einer Vergleichseinrichtung verbunden ist, **dadurch gekennzeichnet**, daß eine Stromumsetzungseinrichtung (R2) mit einer Auswerteeinheit (S) verbunden ist, wobei in Abhängigkeit eines von der Stromumsetzungseinrichtung (R2) bereitgestellten Referenzwertes die Vergleichseinrichtung (V) den an der Auswerteeinheit (S) anliegenden Strom steuert.

2. Schaltungsanordnung nach Anspruch 1, **dadurch gekennzeichnet,** daß zwischen der Stromumsetzungsseinrichtung (R2) und der Auswerteeinheit (S) ein Stromspiegel (T1, R3) geschaltet ist, welcher vom Ausgang der Vergleichseinrichtung (V) derart gesteuert wird, daß der Spannungsabfall an der Strommeßeinrichtung (R1) annähernd gleich dem Spannungsabfall an der Stromumsetzungseinrichtung (R2) ist.

3. Schaltungsanordnung nach Anspruch 1 oder 2, **dadurch gekennzeichnet,** daß die Stromumsetzungseinrichtung (R2) einen inneren Widerstand aufweist, welcher größer ist als der innere Widerstand der Strommeßeinrichtung (R1).

4. Schaltungsanordnung nach einem der vorhergehenden Ansprüche, **dadurch gekennzeichnet,** daß die Vergleichseinrichtung (V) ein Differenzverstärker ist.

5. Schaltungsanordnung nach Anspruch 1 oder 2, **dadurch gekennzeichnet,** daß das Signal über eine Glättungseinrichtung (R4, C2), an die Auswerteinheit (S) geführt ist.

6. Schaltungsanordnung nach Anspruch 1 oder 4, **dadurch gekennzeichnet,** daß an die Vergleichseinrichtung (V) eine Betriebsspannungserhöhungsschaltung (E) geführt ist

7. Schaltungsanordnung nach Anspruch 1, **dadurch gekennzeichnet**, daß die Last eine induktive Last ist.

8. Schaltungsanordnung nach Anspruch 7, **dadurch gekennzeichnet,** daß die induktive Last ein Ventil zum Steuern eines Kompressors einer Klimaanlage ist.

9. Schaltungsanordnung nach Anspruch 1, 7 oder 8, **dadurch gekennzeichnet,** daß die Ansteuerung der Last (L) mit Hilfe eines pulsweitenmodulierten Signals erfolgt.

Figur